## Europäisches Patentamt

## European Patent Office

## Office européen des brevets

(19)

(11) Veröffentlichungsnummer: **0 118 147
B1**

(12) # EUROPÄISCHE PATENTSCHRIFT

(45) Veröffentlichungstag der Patentschrift:
**20.11.86**

(51) Int. Cl.⁴: **G 01 R 1/20**

(21) Anmeldenummer: **84200148.9**

(22) Anmeldetag: **03.02.84**

(54) Mess- und Dämpfungswiderstandsanordnung für ein Hochspannungsgerät.

(30) Priorität: **09.02.83 DE 3304316**

(43) Veröffentlichungstag der Anmeldung:
**12.09.84 Patentblatt 84/37**

(45) Bekanntmachung des Hinweises auf die Patenterteilung:
**20.11.86 Patentblatt 86/47**

(84) Benannte Vertragsstaaten:
**DE FR GB IT**

(56) Entgegenhaltungen:
**CH - A - 155 506
DE - B - 1 155 820
DE - C - 964 624**

(73) Patentinhaber: **Philips Patentverwaltung GmbH,
Billstrasse 80, D-2000 Hamburg 28 (DE)**

(84) Benannte Vertragsstaaten: **DE**

(73) Patentinhaber: **N.V. Philips' Gloeilampenfabrieken,
Groenewoudseweg 1, NL-5621 BA Eindhoven (NL)**

(84) Benannte Vertragsstaaten: **FR GB IT**

(72) Erfinder: **Negle, Hans, Schwalbenweg 15, D-2061 Nahe
(DE)**

(74) Vertreter: **Hartmann, Heinrich, Dipl.-Ing. et al, Philips
Patentverwaltung GmbH
Billstrasse 80 Postfach 10 51 49,
D-2000 Hamburg 28 (DE)**

ACTORUM AG

**Beschreibung**

Die Erfindung betrifft eine Mess- und Dämpfungswiderstandsanordnung für ein Hochspannungsgerät, insbesondere für einen Röntgengenerator, wobei die Messwiderstandsanordnung im Betriebszustand Hochspannung führt und hochspannungsseitig mit der Dämpfungswiderstandsanordnung verbunden ist.

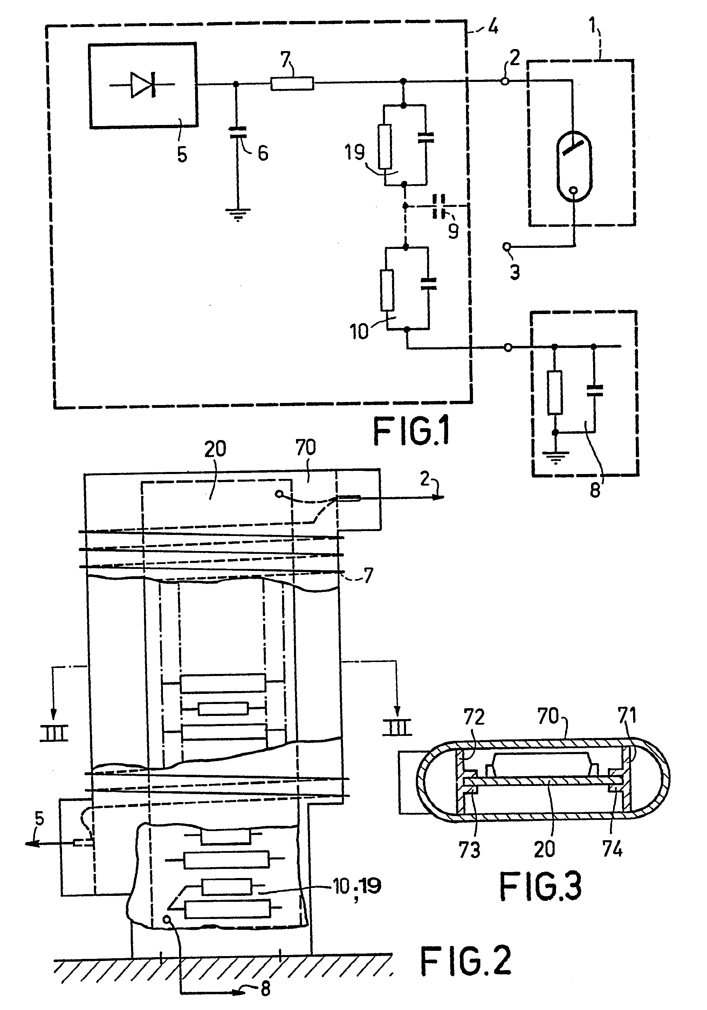

Die Schaltung einer bekannten, als Röntgengenerator ausgebildeten Anordnung dieser Art ist in Fig. 1 dargestellt. Eine Röntgenröhre 1 ist mit ihrem Anodenanschluss 2 an eine positive und mit ihrem Kathodenanschluss 3 an eine negative Hochspannung angeschlossen, die von einem Hochspannungserzeuger 4 geliefert werden. Die gegen Masse positive Hochspannung führende Klemme 2 ist über einen Dämpfungswiderstand 7 mit dem Ausgang eines Hochspannungs-Gleichrichters 5 verbunden, der an einen nicht näher dargestellten Hochspannungs-Transformator angeschlossen ist und dessen Ausgangsspannung durch einen Kondensator 6 geglättet wird. Der Dämpfungswiderstand 7 hat die Aufgabe, im Falle einer Röhrenstörung den Strom durch die Röntgenröhre zu begrenzen.

Die Spannung an der Röntgenröhre kann mittels eines Messteilers gemessen werden, der zwischen den Anschluss 2 und Masse geschaltet ist. Der Messteiler besteht aus zehn in Serie geschalteten RC-Gliedern 10...19, von denen in der Zeichnung nur das erste (10) und das letzte (19) dargestellt sind, die über das Abschluss-RC-Glied 8 mit Masse verbunden ist. Die Widerstände der RC-Glieder 10...19 betragen je 10 MOhm, während der Widerstand des RC-Gliedes 8 nur 10 kOhm beträgt, so dass an jedem der Widerstände der RC-Glieder 10...19 der zehnte Teil der Hochspannung abfällt, und am Widerstand des RC-Gliedes 8 der zehntausendste Teil der Hochspannung anliegt, der zu Messzwecken benutzt werden kann.

Der Teil des Hochspannungserzeugers 4, der die negative Hochspannung für den Anschluss 3 der Röntgenröhre 1 erzeugt, ist identisch aufgebaut wie der bisher beschriebene Teil; jedoch muss der Gleichrichter umgekehrt gepolt sein, damit die erzeugte Hochspannung die umgekehrte Polarität hat.

Es ist wichtig, dass die Spannung am Abschlussglied 8 schnellen Änderungen am Anschluss 2 folgt, d.h. der Messteiler 8, 10...19 muss eine genügend grosse Übertragungsbandbreite haben. Diesem Zweck dienen die parallel geschalteten Kondensatoren in den einzelnen RC-Gliedern, die so bemessen sind, dass sich für jedes RC-Glied die gleiche Zeitkonstante (etwa 10 ms) ergibt. Diese Kondensatoren beseitigen den Einfluss der Zuleitungsinduktivitäten und parasitären Kapazitäten der einzelnen Widerstände. Trotzdem ist auch hierbei die Übertragungsbandbreite begrenzt und ausserdem noch von der Lage der RC-Glieder 10...19, die im folgenden als Messwiderstandsanordnung bezeichnet werden, innerhalb des Hochspannungserzeugers abhängig. Die Ursache dafür sind parasitäre Kapazitäten zwischen den einzelnen RC-Gliedern und ihrer Umgebung, insbesondere dem geerdeten Gehäuse des Hochspannungserzeugers, von denen eine durch den gestrichelten Kondensator 9 in der Zeichnung schematisch dargestellt ist. Wie sich aus dem Schaltbild ohne weiteres ergibt, fliesst nämlich bei schnellen Änderungen der Hochspannung ein Teil des Stromes durch die Messwiderstandsanordnung über diese parasitäten Kapazitäten direkt nach Masse; die über die parasitären Kapazitäten fliessenden Ströme sind um so grösser, je grösser die Hochspannung ist, so dass an dem hochspannungsseitigen RC-Glied 19 ein grösserer Spannungsabfall auftritt als an dem RC-Glied 10, das über das Abschluss-RC-Glied 8 mit Masse verbunden ist. Dies hat eine Beschränkung der Übertragungsbandbreite bzw. eine Verringerung der Messgenauigkeit bei höheren Frequenzen zur Folge.

Aufgabe der vorliegenden Erfindung ist es, eine Anordnung der eingangs genannten Art so auszugestalten, dass bei kompaktem Aufbau auch schnelle Änderungen der Hochspannung gemessen werden können.

Diese Aufgabe wird erfindungsgemäss dadurch gelöst, dass der im Betriebszustand Hochspannungspotential führende Bereich der Messwiderstandsanordnung von der Dämpfungswiderstandsanordnung umschlossen wird.

Es sei an dieser Stelle erwähnt, dass es aus der DE-C-964 624 sowie aus der CH-A-155 506 bereits bekannt ist, einen Hochspannungs-Messwiderstand im Innern eines Schirmwiderstandes anzuordnen, um den elektrischen Feldverlauf zu verbessern. Der Schirmwiderstand, der dem Messwiderstand parallelgeschaltet ist, hat ausschliesslich die eine Funktion, den Messwiderstand nach aussen hin abzuschirmen. Bei der Erfindung wird diese Funktion von der ohnehin vorhandenen Dämpfungswiderstandsanordnung übernommen, die der Messwiderstandsanordnung nicht parallelgeschaltet ist, sondern in Serie dazu liegt und daher nur den im Betriebszustand Hochspannungspotential führenden Bereich der Messwiderstandsanordnung umschliesst. Durch den Wegfall eines gesonderten Schirmwiderstandes führt die Erfindung zu einer Verringerung des Aufwandes und des Bauvolumens.

Bei der Erfindung hat die Dämpfungswiderstandsanordnung ausser der Strombegrenzung noch eine weitere Funktion: Sie schirmt die Messwiderstandsanordnung — zumindest deren hochspannungsseitigen Teil — gegenüber der Umgebung elektrostatisch ab. Es ergeben sich dann zwar zwischen der Messwiderstandsanordnung und der Dämpfungswiderstandsanordnung parasitäre Kapazitäten, doch sind die darüber fliessenden Ströme reduziert, weil die Dämpfungswiderstandsanordnung etwa das gleiche Hochspannungspotential führt wie der von ihr umschlossene Bereich der Messwiderstandsanordnung.

Grundsätzlich wäre es möglich, als Dämpfungswiderstandsanordnung einen hohlzylindrischen stabil aufgebauten Widerstand zu verwenden, doch wäre eine solche Lösung verhältnismässig teuer. Eine bevorzugte Weiterbildung der Erfindung besteht daher darin, dass die Dämpfungswiderstandsanordnung einen Widerstandsdraht enthält, der auf einen isolierenden Körper gewickelt ist, der die Messwiderstandsanordnung umschliesst.

In Fortführung dieser Weiterbildung ist vorgesehen, dass die Messwiderstandsanordnung mehrere auf einem Träger angeordnete Widerstände enthält, die jeweils kapazitiv überbrückt sind und dass der isolierende Körper als Halterung für den Träger ausgebildet ist.

Die Erfindung wird nachstehend anhand der Figuren 2 und 3 näher erläutert. Es zeigen:

Fig. 2 eine Seitenansicht und

Fig. 3 einen Schnitt durch die Anordnung der Fig. 2 längs der Linien A-A'.

Wie aus Fig. 2 und 3 ersichtlich, ist eine Leiterplatte 20 im Innern eines hohlzylindrischen isolierenden Körpers 70 — herausnehmbar — angeordnet, der parallel zur Zylinderachse verlaufende Stege 71, 72 mit Führungen 73 bzw. 74 aufweist, innerhalb derer die Leiterplatte in Richtung der Zylinderachse verschoben werden kann und die der Halterung der Leiterplatte dienen. Die Leiterplatte dient als Träger für die RC-Glieder 10...19, die auf ihr in der Reihenfolge der im Betriebszustand anliegenden Hochspannungen angeordnet sind, so dass im Betriebszustand die Potentiale auf der Leiterplatte in Richtung der Zylinderachse von unten nach oben zunehmen.

Auf den Bereich des isolierenden Körpers 70, der die oberen RC-Glieder umschliesst, ist von aussen ein Widerstandsdraht 7 gewickelt, der in der Schaltung als Dämpfungswiderstand fungiert und im Hochspannungsgerät zwischen den Verbraucher (Röntgenröhre 1) und die Hochspannungquelle (Gleichrichter 5) geschaltet ist, wobei sein eines Ende elektrisch leitend mit dem hochspannungsseitigen Anschluss der Messwiderstandsanordnung verbunden ist. Der Widerstandsdraht 7 ist so bemessen und angeordnet, dass die im Kurzschlussfall erzeugte Wärmeenergie im Dämpfungswiderstand gespeichert und die im stationären Betrieb entstehende Wärme kontinuierlich an das Isoliermedium (z.B. Transformatoröl) im Hochspannunggerät abgegeben werden kann. Ausserdem ist der Widerstandsdraht so angeordnet und der isolierende Körper 70 so bemessen, dass sich weder im Normalbetrieb noch im Kurzschlussfall innere oder äussere Überschläge ergeben können.

Der von dem Widerstandsdraht 7 umschlossene obere Teil der Messwiderstandsanordnung ist dabei weitgehend gegen äussere elektrische Felder abgeschirmt, so dass die über parasitäre Kapazitäten abgeleiteten Ströme wesentlich verringert werden. Wenn die Messwiderstandsanordnung entsprechend Fig. 1 zu einem Messteiler ergänzt wird, ergibt sich mit der in Fig. 2 und Fig. 3 dargestellten Anordnung eine 3 dB-Grenzfrequenz von etwa 200 kHz, die sich auf etwa 30 kHz erniedrigt, wenn die Abschirmung durch den Widerstandsdraht entfällt. Ein weiterer Vorteil der erfindungsgemässen Anordnung besteht darin, dass die Übertragungsbandbreite weitgehend unabhängig davon ist, wo innerhalb des Hochspannungsgerätes die Anordnung eingebaut wird. Man kann sie also in Hochspannungsgeräten unterschiedlichen Typs verwenden, ohne befürchten zu müssen, dass sich dadurch die Übertragungsbandbreite ändert. Ein weiterer Vorteil der Abschirmung besteht darin, dass der erhöhte Spannungsabfall an den oberen RC-Gliedern abgebaut wird, so dass eine Überlastung auch bei Stossbelastungen (Einlaufen von Wanderwellen bei Störungen in der Röntgenröhre in einem Röntgengenerator) sicher vermieden wird.

Weitere Vorteile der Erfindung sind die Reduzierung des für die erfindungsgemässe Anordnung erforderlichen Einbauvolumens und die Verringerung der Herstellungskosten, weil der isolierende Körper 70 gleichzeitig den Widerstandsdraht 7 trägt und die Platte 20 haltert. Die notwendigen Isolationsstrecken gegenüber dem Erdpotential können somit gemeinsam genutzt werden, wodurch die gesamte Anordnung; Dämpfungswiderstand und Messwiderstandsanordnung erheblich — etwa um die Hälfte — reduziertes Einbauvolumen benötigt.

Eine noch höhere Übertragungbandbreite kann dadurch erreicht werden, dass anstelle der Zylinderform der Wicklung und des isolierenden Körpers eine (Glocken-)Form gewählt wird derart, dass die sich dadurch ergebende Potentialverteilung weitgehend mit der Potentialverteilung auf der Leiterplatte übereinstimmt.

## Patentansprüche

1. Mess- und Dämpfungswiderstandsanordnung für ein Hochspannungsgerät, insbesondere für einen Röntgengenerator, wobei die Messwiderstandsanordnung (10...19) im Betriebszustand Hochspannung führt und hochspannungsseitig mit der Dämpfungswiderstandsanordnung (7) verbunden ist, dadurch gekennzeichnet, dass der im Betriebszustand Hochspannungspotential führende Bereich der Messwiderstandsanordnung (10...19) von der Dämpfungswiderstandsanordnung (7) umschlossen wird.

2. Anordnung nach Anspruch 1, dadurch gekennzeichnet, dass die Messwiderstandsanordnung mehrere auf einem Träger (20) angeordnete, kapazitiv überbrückte und in Serie geschaltete Widerstände (10...19) umfasst.

3. Anordnung nach Anspruch 1, dadurch gekennzeichnet, dass die Dämpfungswiderstandsanordnung durch einen Widerstandsdraht (7) gebildet wird, der auf einem die Messwiderstandsanordnung (10...19) umschliessenden isolierenden Körper (70) gewickelt ist.

4. Anordnung nach Anspruch 2 oder 3, dadurch gekennzeichnet, dass der Körper (70) als Halterung für den Träger (20) ausgebildet ist.

## Claims

1. A measuring and damping resistor arrangement for a high-voltage apparatus, notably for an X-ray generator, in which the measuring resistor arrangement (10...19) carries a high voltage and is connected to the damping resistor arrangement (7) on the high-voltage side in the operating condition, characterized in that the part of the measuring resistor arrangement (10...19) which carries high-voltage potential in the operating condition is enclosed by the damping resistor arrangement (7).

2. An arrangement as claimed in Claim 1, characterized in that the measuring resistor arrangement comprises several series-connected resistors (10... 19) which are arranged on a support (20) and which are capacitively bridged.

3. An arrangement as claimed in Claim 1, characterized in that the damping resistor arrangement is formed by a resistance wire (7) which is wound onto an insulating body (70) which encloses the measuring resistor arrangement (10...19).

4. An arrangement as claimed in Claim 2 and 3, characterized in that the insulating body (70) is constructed as a holder for the support (20).

**Revendications**

1. Montage de résistance de mesure et d'amortissement pour un appareil à haute tension, en particulier pour un générateur de rayons X, dans lequel le montage de résistance de mesure (10...19) conduit, en service, une haute tension et est connecté du côté de la haute tension au montage de résistance d'amortissement (7), caractérisé en ce que la zone du montage de résistance de mesure (10...19) qui, en service, conduit le potentiel de haute tension est entourée par le montage de résistance d'amortissement (7).

2. Montage suivant la revendication 1, caractérisé en ce que le montage de résistance de mesure comprend plusieurs résistances (10...19) montées sur un support (20) pontées de manière capacitive et connectées en série.

3. Montage suivant la revendication 1, caractérisé en ce que le montage de résistance d'amortissement est formé par un fil de résistance (7) qui est bobiné sur un corps isolant (70) entourant le montage de résistance de mesure (10...19).

4. Montage suivant les revendications 2 et 3, caractérisé en ce que le corps (70) a la forme d'une fixation pour le support (20).

FIG.1

FIG.2

FIG.3